# EUROPÄISCHE PATENTSCHRIFT

(11) **EP 3 245 158 B1**
(45) Veröffentlichungstag und Bekanntmachung des Hinweises auf die Patenterteilung: **06.11.2019**
(21) Anmeldenummer: 15822946.8
(22) Anmeldetag: 23.12.2015
(51) Int. Cl.: C01B 32/956, D01F 9/08, B01J 19/02, B01J 19/18

(54) **VORRICHTUNG UND VERFAHREN ZUM HERSTELLEN VON SILIZIUMCARBID**
DEVICE AND METHOD FOR PRODUCING SILICON CARBIDE
DISPOSITIF ET PROCÉDÉ DE FABRICATION DE CARBURE DE SILICIUM

(30) Priorität: 06.01.2015 DE 102015100062
(43) Veröffentlichungstag der Anmeldung: 22.11.2017
(73) Patentinhaber: Universität Paderborn, 33098 Paderborn (DE)
(72) Erfinder: GREULICH-WEBER, Siegmund, 33175 Bad Lippspringe (DE)
(74) Vertreter: Michalski Hüttermann & Partner Patentanwälte mbB
(86) Internationale Anmeldenummer: PCT/EP2015/081185
(87) Internationale Veröffentlichungsnummer: WO 2016/110418

(56) Entgegenhaltungen:
- WO-A1-2004/111316
- DE-T2- 69 518 071
- RU-C1- 2 296 827

## Beschreibung

Die vorliegende Erfindung betrifft eine Vorrichtung und ein Verfahren zum Herstellen von kristallinem Siliziumcarbid, insbesondere von nanostrukturiertem kristallinem Siliziumcarbid.

Siliziumcarbid ist für eine Vielzahl von Anwendungen bevorzugt. So ist es beispielsweise bekannt, Siliziumcarbid als Elektrodenmaterial für Batterien, wie etwa für Lithium-Ionen-Batterien zu verwenden. Die Herstellung von kristallinem Siliziumcarbid, insbesondere in nano- oder mikrokristallinem Maßstab ist dabei ein komplexer Vorgang, der einer genauen Steuerung bedarf, um definiertes Siliziumcarbid etwa in Form von nanokristallinen Fasern zu erzeugen.

Grundsätzlich ist für die Faserherstellung eine Vielzahl von Vorrichtungen bekannt. So beschreiben die Dokumente RU 2296827, RU 2389836 und RU2409711 Reaktoren zur Herstellung von Carbonfasern. Diese Dokumente offenbaren, dass die Fasern an einer Scheibe abgeschieden und von dieser durch einen Kratzer entfernt werden. Dabei werden jedoch insbesondere diskontinuierliche Prozesse verwendet.

Das Dokument JP2013049599 beschreibt eine Vorrichtung zum Herstellen von Kohlenstoff-Nanospulen, der einen Reaktor zum Ausbilden der Nanospulen aufweist. Dabei können die erzeugten Nanospulen durch ein Öffnungsmittel in einen Auffangbehälter gelangen.

Die Dokumente WO 02/30816 und JP2005171443 A beschreiben jeweils Reaktoren zum Herstellen von Kohlenstofffasern, bei denen sich die Fasern auf einem Substrat innerhalb eines Reaktors bilden und von dem Substrat innerhalb des Reaktors abgeschabt werden, um in dem Reaktor gesammelt zu werden.

Aus dem Dokument WO 01/16414 A1 ist ferner eine Vorrichtung zum Erzeugen von Kohlefasern bekannt, bei der die Kohlefasern in einem Reaktor erzeugt werden.

Das Dokument DE 691 19 838 T2 beschreibt eine Vorrichtung zum Herstellen von dünnen Kohlenstofffasern. Diese Vorrichtung basiert auf einer Herstellung der Fasern durch DampfPhasen-Pyrolyse. Dabei ist ein Fördermittel vorgesehen, auf welchem für die Faserherstellung notwendige Komponenten durch einen Ofen gefördert werden, um die Fasern zu bilden.

Das Dokument JP 09143717 A beschreibt eine Vorrichtung für eine Vakuum-Gasphasenabscheidung. Bei dieser Vorrichtung sollen unmittelbar Substrate beschichtet werden, welche automatisch an einer rotierenden Scheibe befestigt oder von dieser gelöst werden sollen.

Aus den Dokumenten WO 2009/029341 A2 und US 8,246,886 B2 sind ferner Vorrichtungen zum Verarbeiten von Kohlenstoff-Nanoröhrchen bekannt. In diesen Vorrichtungen werden bereits bestehende Nanoröhrchen weiterverarbeitet, eine Vorrichtung zum Erzeugen von Kohlenstoff-Nanoröhrchen beschreiben diese Dokumente nicht.

Aus dem Dokument US 2009/0053115 A1 ist eine Vorrichtung zum Erzeugen von ausgerichteten Kohlenstoff-Nanoröhrchen bekannt. Bei Verwendung dieses Reaktors werden Substrate durch einen Reaktor transportiert, auf welchen die Nanoröhrchen aufwachsen.

DE 695 18 071 T1 beschreibt ein Verfahren zur Herstellung von Keramikpulvern, umfassend das Vereinen einer Vorstufenverbindung mit einem Trägergas unter Bildung eines Vorstufe/Trägergas-Stroms, wobei die Vorstufenverbindung eine verdampfte metallorganische Verbindung umfasst, rasches Erhitzen des Vorstufe/Trägergas-Stroms auf eine Temperatur von etwa 500°C bis etwa 1400°C, zwecks thermischer Zersetzung der metallorganischen Vorstufe, und Bildung von nanostrukturiertem Keramikpulver. Weiter von dem Verfahren umfasst ist das Lenken des nanostrukturierten Keramikpulvers in einem scharfen Strahl auf eine gekühlte Oberfläche und das Entfernen der Partikel von der Oberfläche, wodurch nicht agglomerierte nanostrukturierte Keramikpulver entstehen.

Keines der vorbeschriebenen Dokumente bezieht sich jedoch unmittelbar auf die Herstellung von kristallinem Siliziumcarbid, insbesondere in Form nanokristalliner Fasern, so dass die Vorrichtungen aus dem vorzitierten Stand der Technik einem fremden technischen Gebiet zuzuordnen sind und für die Herstellung von Siliziumcarbid, insbesondere in nanokristalliner Faserform, nicht geeignet scheinen.

Es ist daher die Aufgabe der vorliegenden Erfindung, eine Maßnahme zu schaffen, durch welche auf kostengünstige Weise ein kontinuierliches Herstellen von Siliziumcarbid, insbesondere in Form von nanokristallinen Fasern, ermöglicht werden kann.

Die Lösung der Aufgabe erfolgt erfindungsgemäß durch eine Vorrichtung mit den Merkmalen des Anspruchs 1. Die Lösung der Aufgabe erfolgt ferner durch ein Verfahren mit den Merkmalen des Anspruchs 10. Bevorzugte Ausgestaltungen der Erfindung sind in den Unteransprüchen, in der Beschreibung, in der Figur und dem Beispiel offenbart, wobei weitere in den Unteransprüchen oder in der Beschreibung oder der Figur oder dem Beispiel beschriebene oder gezeigte Merkmale einzeln oder in einer beliebigen Kombination einen Gegenstand der Erfindung darstellen können, wenn sich aus dem Kontext nicht eindeutig das Gegenteil ergibt.

Die vorliegende Erfindung betrifft eine Vorrichtung zum kontinuierlichen Herstellen von kristallinem Siliziumcarbid, aufweisend
- einen Reaktor und
- einen von dem Reaktor zumindest teilweise räumlich getrennten Sammelbehälter, wobei
- der Reaktor eine Zuführung zum Zuführen eines Präkursorgemisches aufweist,
- ein Substrat zum Abscheiden von kristallinem Siliziumcarbid vorgesehen ist,
- ein Reaktionsraum des Reaktors auf eine erste Temperatur T₁ und das Substrat auf eine von der ersten Temperatur T₁ verschiedene zweite Temperatur T₂ temperierbar ist, wobei der Reaktor auf eine Temperatur erhitzbar ist, die in einem Bereich von ≥ 1400°C bis ≤ 2000°C liegt und wobei die Temperatur des Substrats um eine Temperatur verringerbar ist, die in einem Bereich von ≥ 50°C bis ≤ 100°C liegt, verglichen zu der grundsätzlich in dem Reaktor eingestellten Temperatur in dem vorgenannten Bereich von ≥ 1400°C bis ≤ 2000°C, wobei
- das Substrat zum Abscheiden von kristallinem Siliziumcarbid in einer Abscheideposition in oder benachbart zu dem Reaktionsraum anordbar ist und zumindest bereichsweise von der Abscheideposition zu dem Sammelbehälter bewegbar ist, und wobei
- ein Abstreifer derart angeordnet ist, dass nach oder bei einem zumindest bereichsweisen Bewegen des Substrates zu dem Sammelbehälter an dem Substrat abgeschiedenes kristallines Siliziumcarbid durch den Abstreifer von dem Substrat lösbar und das gelöste kristalline Siliziumcarbid in den Sammelbehälter überführbar ist.

Eine derartige Vorrichtung erlaubt auf einfache und kostengünstige Weise ein definiertes und kontinuierliches Herstellen von qualitativ hochwertigem Siliziumcarbid, insbesondere in Form von nanokristallinen Fasern.

Die vorbeschriebene Vorrichtung dient dem Herstellen von kristallinem Siliziumcarbid und dabei insbesondere dem Herstellen beziehungsweise Erzeugen von nanostrukturiertem Siliziumcarbid in Faserform. Für ein Erzeugen eines derartigen Produkts wird insbesondere eine Vorrichtung benötigt, bei welcher durch Einstellung höchst definierter Bedingungen auf besonders reproduzierbare Weise Kristalle des Siliziumcarbids in Form von Fasern erzeugt werden können.

Die Vorrichtung umfasst einen Reaktor und einen von dem Reaktor zumindest teilweise räumlich getrennten Sammelbehälter. Somit sind bei einer vorbeschriebenen Vorrichtung wenigstens zwei Kammern beziehungsweise Behälter vorgesehen, die zumindest teilweise, insbesondere vollständig, räumlich voneinander getrennt sind. Das kann im Sinne der vorliegenden Erfindung insbesondere bedeuten, dass zwischen den beiden Behältern beziehungsweise Volumina eine räumliche Trennung, wie beispielsweise eine Wandung oder ähnliches, vorgesehen ist, und somit nicht lediglich getrennte Bereiche eines gemeinsamen Behältnisses vorliegen sondern insbesondere vollständig voneinander getrennte Volumina vorgesehen sind. Somit wird es möglich, dass innerhalb des Reaktor und innerhalb des Sammelbehälters unterschiedliche Bedingungen, wie insbesondere unterschiedliche Temperaturen und/oder Drücke herrschen können. Beispielsweise können thermische Isolierungen zwischen dem Reaktor und dem Sammelbehälter vorliegen, um dies zu ermöglichen oder zu verbessern.

Um Siliziumcarbid zu erzeugen, weist der Reaktor eine Zuführung zum Zuführen eines Präkursorgemisches auf. Das Präkursorgemisch dient dabei insbesondere als Ausgangsstoff für das zu erzeugende Siliziumcarbid und kann neben den Edukten auch einen Katalysator, Dotierstoff oder ähnliches aufweisen, wie dies nachstehend mit Bezug auf das Verfahren im Detail beschrieben wird.

Die vorliegende Vorrichtung basiert insbesondere darauf, das Präkursorgemisch zumindest teilweise in die Gasphase zu überführen und an einem Substrat das gewünschte Produkt abscheiden zu können. Entsprechend ist bei einer vorbeschriebenen Vorrichtung ein Substrat zum Abscheiden von kristallinem Siliziumcarbid vorgesehen. Das Substrat dient somit als Abscheideoberfläche, auf welcher sich Siliziumcarbid kristallin abscheiden kann. Entsprechend ist das Substrat zum Abscheiden von kristallinem Siliziumcarbid in oder benachbart zu dem Reaktor beziehungsweise dem Reaktionsraum in einer Abscheideposition anordbar. Das bedeutet insbesondere, dass das Substrat und damit zumindest ein Teil des Substrats derart angeordnet ist, dass die Gasphase, in welcher sich die Ausgangssubstanz beziehungsweise die Ausgangssubstanzen für die Siliziumcarbidbildung befinden, in Kontakt mit dem Substrat gelangen kann.

Um ein Abscheiden des Siliziumcarbids aus der Gasphase zu gewährleisten, ist es von Vorteil, dass die Temperatur in dem Reaktor und die Temperatur des Substrats von einander verschieden sind. Im Detail kann es bevorzugt sein, dass innerhalb des Reaktors beziehungsweise in dem Reaktionsraum des Reaktor, eine ausreichend hohe Temperatur vorliegt, um die entsprechenden Substanzen in die Gasphase zu bringen beziehungsweise in der Gasphase zu halten. Somit ist der Reaktionsraum insbesondere das Volumen, in welchem die Ausgangssubstanzen der Siliziumcarbidherstellung in die Gasphase gehen beziehungsweise in der Gasphase bleiben. Um die gewünschte Abscheidung beziehungsweise Kristallisierung zu ermöglichen kann es ferner von Vorteil sein, dass das Substrat eine Temperatur aufweist, die verglichen zu der Temperatur in dem Reaktionsraum reduziert ist. In anderen Worten ist es zum Abscheiden der Siliziumcarbid-Kristalle von Vorteil, dass das Innere des Reaktors auf eine erste Temperatur T₁ und das Substrat auf eine von der ersten Temperatur T₁ verschiedene zweite Temperatur T₂ temperierbar ist, wobei T₂ bevorzugt kleiner als T₁ ist, wobei der Reaktor auf eine Temperatur erhitzbar ist, die in einem Bereich von ≥ 1400°C bis ≤ 2000°C liegt und wobei die Temperatur des Substrats um eine Temperatur verringerbar ist, die in einem Bereich von ≥ 50°C bis ≤ 100°C liegt, verglichen zu der grundsätzlich in dem Reaktor eingestellten Temperatur in dem vorgenannten Bereich von ≥ 1400°C bis ≤ 2000°C.

Dabei kann es ferner durch die vorbeschriebene Einstellbarkeit der Temperatur ermöglicht werden, dass das erzeugte Siliziumcarbid nanokristallin ist und im Detail eine kubische 3C-Struktur des Siliziumcarbids ermöglicht wird. Insbesondere, wenn das Siliziumkarbid (SiC) als Siliziumkarbid-Einkristall, vorzugsweise als monokristallines kubisches 3C-SIC vorliegt, vereinen die einkristallinen Siliziumkarbid-Fasern eine hohe thermische Leitfähigkeit. Somit kann durch die gezielte Einstellbarkeit eines Temperaturgradienten zwischen dem Reaktor und dem Substrat es ermöglicht werden, dass sich kristallines Siliziumcarbid abscheidet.

Insbesondere, um einen kontinuierlichen Prozess zu ermöglichen, ist es bei der vorbeschriebenen Vorrichtung vorgesehen, dass das Substrat zumindest bereichsweise von dem Reaktor beziehungsweise von seiner Abscheideposition zu dem Sammelbehälter bewegbar ist. Das soll im Sinne der vorliegenden Erfindung insbesondere bedeuten, dass das Substrat zumindest bereichsweise, also zumindest ein Teil desselben, in eine Position an beziehungsweise benachbart zu dem Sammelbehälter bewegbar ist, so dass abgeschiedenes Siliziumcarbid in dem Sammelbehälter überführbar ist. Dadurch kann das erzeugte Siliziumcarbid in dem Sammelbehälter gesammelt beziehungsweise gelagert werden. Dies kann insbesondere dann von Vorteil sein, wenn das Substrat oder eine Mehrzahl von Substraten derart vorgesehen beziehungsweise angeordnet sind, dass es gleichzeitig ermöglicht wird, dass auf dem oder einem Substrat Siliziumcarbid abgeschieden wird und dass ferner von einer anderen Position des Substrats oder einem anderen Substrat sich bereits gebildetes Siliziumcarbid gelöst wird und in den Sammelbehälter überführt wird. In dieser Ausgestaltung kann bevorzugt ohne signifikante Pause und damit kontinuierlich unter definierten Bedingungen Siliziumcarbid erzeugt werden. Dazu braucht lediglich das Präkursorgemisch in auseichender Menge und kontinuierlich oder diskontinuierlich in den Reaktor eingebracht werden.

Aus dem Vorstehenden wird es ferner ersichtlich, dass das Vorsehen eines Reaktor und eines von dem Reaktor zumindest teilweise räumlich getrennten Sammelbehälters vorteilhaft ist, da so das gebildete Siliziumcarbid bei vergleichsweise niedrigen Temperaturen problemlos gelagert werden kann, wohingegen gleichzeitig in dem Reaktor Siliziumcarbid gebildet werden kann.

Bei der vorliegenden Vorrichtung ist es ferner vorgesehen, dass ein Abstreifer, der feststehend beziehungsweise unbeweglich sein kann, vorgesehen ist, und somit, dass genau ein oder eine Mehrzahl an Abstreifern vorgesehen ist. Der Abstreifer soll insbesondere dazu dienen und somit derart ausgestaltet beziehungsweise angeordnet sein, dass sich an dem Substrat gebildetes Siliziumcarbid lösen kann beziehungsweise dieses durch den Abstreifer von dem Substrat abgestrichen werden kann. Hierzu ist der Abstreifer insbesondere an oder benachbart zu dem Sammelbehälter angeordnet, so dass von dem Abstreifer gelöste Kristalle in den Sammelbehälter überführt werden können. In anderen Worten ist der Abstreifer derart angeordnet, dass nach einem zumindest bereichsweisen Bewegen des Substrates zu dem Sammelbehälter an dem Substrat abgeschiedenes kristallines Siliziumcarbid durch den Abstreifer von dem Substrat lösbar und das gelöste kristalline Siliziumcarbid in den Sammelbehälter überführbar ist.

Eine vorbeschriebene Vorrichtung erlaubt einen kontinuierlichen und damit effektiven und ökonomischen Prozess der Herstellung von Siliziumcarbid, insbesondere in Form nanokristalliner Fasern. Somit kann Siliziumcarbid besonders kostengünstig und dabei qualitativ hochwertig hergestellt werden.

Die Kostengünstigkeit kann beispielsweise dadurch ermöglicht werden, dass die Vorrichtung einen vergleichsweise einfachen und kostengünstigen Aufbau aufweist und dabei einfach herstellbar ist. Beispielsweise ist es nicht notwendig, die Vorrichtung in einem Vakuum zu betreiben, sondern es kann mit einem leichten Schutzgasüberdruck gearbeitet werden, wodurch etwa auf Hochtemperatur- oder Vakuumdichtungen wie auch auf eine Vakuumpumpe verzichtet werden kann.

Weiterhin bietet die vorbeschriebene Vorrichtung den Vorteil, dass diese das Herstellen von qualitativ äußerst hochwertigem Siliziumcarbid ermöglicht, da sehr definierte Bedingungen einstellbar sind. Die eingestellten Parameter sind dabei nicht nur definiert einstellbar, sondern darüber hinaus auch problemlos an das gewünschte Anwendungsgebiet anpassbar, so dass ferner nicht nur qualitativ hochwertige sondern ferner besonders anpassbare beziehungsweise variable Siliziumcarbid-Kristalle erzeugt werden können. Die hierzu einzustellenden Parameter umfassen beispielsweise die gewählte Temperatur innerhalb des Reaktors beziehungsweise in dem Reaktionsraum und die gewählte Temperatur des Substrats, einschließlich des gewählten Temperaturgradienten zwischen Reaktionsraum und Substrat, und ferner die Geschwindigkeit der Bewegung des Substrats von der Abscheideposition zu dem Sammelbehälter, etwa bei einem kontinuierlichen Bewegen, oder auch die Zeitdauer des Aufenthalts des Substrats in der Abscheideposition, oder auch die zugegebene Menge an Präkursormischung je Zeiteinheit.

Durch eine geeignete Auswahl der vorbeschriebenen Parameter, beispielsweise, lassen sich auf einfache und definierte Weise die Eigenschaften der erzeugten Siliziumcarbid-Kristalle einstellen, wie etwa der Durchmesser von erzeugten kristallinen Fasern, deren Länge und kristalline Qualität.

In einer bevorzugten Ausgestaltung kann es vorgesehen sein, dass das Substrat als rotierbare Scheibe ausgebildet ist. Insbesondere in dieser Ausgestaltung kann es auf einfache Weise ermöglicht werden, dass ein kontinuierlicher Prozess realisierbar ist. Denn die rotierbare Scheibe kann stets mit einem Bereich in oder benachbart zu dem Reaktor beziehungsweise seinem Reaktionsraum, also in der Abscheideposition, vorliegen, wohingegen ein weiterer Bereich benachbart zu dem Sammelbehälter vorliegen kann. Dadurch kann auch bei einer kontinuierlich rotierenden Scheibe stets Siliziumcarbid abgeschieden beziehungsweise erzeugt werden und vormals erzeugtes Siliziumcarbid kann gleichzeitig durch den Abstreifer gelöst und in den Sammelbehälter überführt werden. Dabei ist ferner eine einfache Anpassung an das gewünschte zu erzeugende Siliziumcarbid möglich, da die Rotationsgeschwindigkeit der Scheibe ein einfach und definiert einzustellender Parameter ist. Dies kann insbesondere der Fall sein, wenn die Scheibe um ihre Scheibenachse rotierbar ist.

Es kann weiterhin bevorzugt sein, dass der Abstreifer benachbart zu einer Einfallöffnung des Sammelbehälters angeordnet ist derart, dass das von dem Substrat gelöste kristalline Siliziumcarbid in den Sammelbehälter fällt. Unter einer Einfallöffnung kann insbesondere eine derartige Öffnung verstanden werden, die derart angeordnet ist, dass das abgestreifte Siliziumcarbid durch die Einfallöffnung in den Sammelbehälter fallen kann. In dieser Ausgestaltung kann wiederum eine besonders einfache Ausgestaltung ermöglicht werden, da lediglich der Abstreifer entsprechend angeordnet werden braucht und ansonsten ein kontinuierliches und fehlerfreies Arbeiten gewährleistet sein kann, da das Siliziumcarbid einfach unter Ausnutzung der Schwerkraft in den Sammelbehälter überführt werden kann.

In einer weiteren vorteilhaften Ausgestaltung kann es vorgesehen sein, dass der Reaktor und der Sammelbehälter als kopfseitig geöffnete Behälter ausgebildet sind, wobei das Substrat oberhalb kopfseitiger Öffnungen des Reaktors und des Sammelbehälters anordbar ist. Diese Ausgestaltung kann wiederum besonders einfach ausbildbar sein, da bezüglich eines in Kontakt bringens der in der Gasphase befindlichen Präkursoren mit dem Substrat wie auch bezüglich einer Öffnung des Sammelbehälters beziehungsweise der Positionierung des Abstreifers, um das von dem Substrat gelöste Siliziumcarbid in den Sammelbehälter zu überführen, keine großen Anforderungen gestellt sind. Vielmehr kann der Prozess auf einfache Weise und mit definierten Bedingungen durchgeführt werden.

In einer weiteren vorteilhaften Ausgestaltung kann es vorgesehen sein, dass eine Wandung des Reaktors Graphit aufweist, beispielsweise aus Graphit besteht. Insbesondere in dieser Ausgestaltung kann der Reaktor zum Einen kostengünstig ausgestaltet werden und kann auf der anderen Seite hohen Temperaturen gut standhalten, ohne dabei etwa durch Luftsauerstoff beschädigt oder zerstört zu werden. Somit kann in dieser Ausgestaltung eine besonders hohe Langlebigkeit der Vorrichtung ermöglicht werden.

Es kann besonders bevorzugt sein, wenn die Wandung des Reaktors zumindest teilweise aus einer gewickelten Graphitfolie ausgestaltet ist, beispielsweise aus dieser besteht. In dieser Ausgestaltung kann die Vorrichtung besonders langlebig sein, da es sich in überraschender Weise herausgestellt hat, dass die Wandung einem Temperaturwechsel besonders gut standhalten kann. Während des Betriebs kann es oftmals nicht vollkommen ausgeschlossen werden, dass sich das Graphit der Wandung, die unabhängig von dem Material etwa als Zylinder ausgestaltet sein kann, in Siliziumcarbid umwandelt. Die unterschiedlichen Wärmeausdehnungskoeffizienten von Graphit und Siliziumcarbid können dabei zu thermisch bedingten Spannungen führen, die bei einer gewickelten Wandung aus einer Graphitfolie besonders leicht und problemlos abbaubar sind beziehungsweise nicht oder nur vermindert auftreten. Dadurch kann wiederum eine besonders hohe Langlebigkeit der Wandung und damit der Vorrichtung ermöglicht werden.

In einer weiteren vorteilhaften Ausgestaltung kann es vorgesehen sein, dass der Abstreifer zumindest teilweise aus Siliziumcarbid ausgestaltet ist, beispielsweise aus Siliziumcarbid besteht. In dieser Ausgestaltung kann ein qualitativ besonders hochwertiges kristallines Siliziumcarbid erzeugt werden, da der Abstreifer keine Verunreinigungen in das abgestreifte Siliziumcarbid einbringt. Dies kann insbesondere deshalb von Vorteil sein, da nanokristallines Siliziumcarbid erzeugt wird.

In einer weiteren vorteilhaften Ausgestaltung kann es vorgesehen sein, dass ein Temperiermittel zum Temperieren des Reaktors vorgesehen ist und dass ein weiteres Temperiermittel zum Temperieren des Substrats vorgesehen ist, wobei das Temperiermittel zum Temperieren des Reaktors und das Temperiermittel zum Temperieren des Substrats getrennt voneinander ansteuerbar sind. In dieser Ausgestaltung kann durch ein getrenntes Ansteuern der Temperiermittel ein besonders definiert einstellbarer Temperaturgradient zwischen dem Gasvolumen in dem Reaktor und dem Substrat eingestellt werden. Beispielsweise können zwei Temperiermittel vorgesehen sein, von denen eines die Wandung des Reaktors temperieren, also insbesondere heizen, kann, und kann ein weiteres Temperiermittel vorgesehen sein, welches auf das Substrat wirkt, etwa von einer dem Reaktor entgegengesetzt angeordneten Seite beziehungsweise einer der Abscheideoberfläche des Substrats entgegengesetzt angeordneten Seite, um so die entsprechenden Temperaturen einstellen zu können. In dieser Ausgestaltung können somit besonders definierte Bedingungen einstellbar sein und kann somit ein qualitativ besonders hochwertiges und definiertes Siliziumcarbid erzeugt werden.

In einer weiteren vorteilhaften Ausgestaltung kann es vorgesehen sein, dass der Sammelbehälter und der Reaktor jeweils eine Materialschleuse zum Austragen eines Feststoffes aufweisen. Durch das Vorsehen entsprechender Materialschleusen, wie etwa Festkörperschleusen, wird es möglich, während des Betriebs der Vorrichtung etwa das in dem Sammelbehälter befindliche Siliziumcarbid aus der Sammelbehälter zu entfernen oder auch Reste der Präkursormischung aus dem Reaktor zu entfernen. Dadurch kann auch über einen langen Zeitraum der kontinuierliche Prozess beibehalten werden.

Hinsichtlich weiterer Vorteile und technischer Merkmale der vorbeschriebenen Vorrichtung wird hiermit explizit auf die Beschreibung des Verfahrens sowie auf das Beispiel, die Figur und die Beschreibung der Figur Bezug genommen, und umgekehrt.

Die vorliegende Erfindung betrifft ferner ein Verfahren zum Herstellen von kristallinem Siliziumcarbid unter Verwendung einer Vorrichtung, wie diese vorstehend im Detail beschrieben ist, aufweisend die Verfahrensschritte:
a) Einfügen eines Präkursorgemisches mit einer Siliziumquelle, einer Kohlenstoffquelle und gegebenenfalls einem Dotierstoff in den Reaktor;
b) Beaufschlagen des in Verfahrensschritt a) bereitgestellten Präkursorgemisches mit einer Vergasungstemperatur in dem Reaktor;
c) Abscheiden von kristallinem Siliziumcarbid an dem Substrat durch Einstellen einer Kristallisierungstemperatur an dem Substrat;
d) Bewegen des Substrats zu dem Abstreifer; und
e) Überführen des gebildeten Siliziumcarbids in den Sammelbehälter durch Lösen des gebildeten Siliziumcarbids von dem Substrat unter Entlangbewegen des Substrats an dem Abstreifer.

Durch das vorbeschriebene Verfahren kann auf einfache und definierte Weise qualitativ hochwertiges Siliziumcarbid erzeugt werden. Dabei können die vorgenannten Verfahrens schritte a) bis e) grundsätzlich in der genannten Reihenfolge zumindest teilweise zeitgleich oder auch in einer zumindest teilweise abweichenden Reihenfolge durchgeführt werden. Für das vorbeschriebene Verfahren wird insbesondere eine Vorrichtung verwendet, wie diese vorstehend im Detail beschrieben ist. Mit Bezug auf die Vorrichtung wird daher auf die vorstehenden Ausführungen Bezug genommen.

Dabei kann das Verfahren vollständig oder können einzelne der Verfahrensschritte a) bis e) vorzugsweise unter Schutzgas, wie insbesondere Argon oder Stickstoff, ablaufen. Dazu kann beispielsweise ein Schutzgaseinlass an dem Reaktor und/oder an dem Sammelbehälter vorgesehen sein, durch welchen der Reaktor und/oder der Sammelbehälter mit Schutzgas gefüllt und gegebenenfalls mit einem Schutzgasüberdruck betrieben werden. So kann das gebildete Siliziumcarbid ferner unter Schutzgas dem Sammelbehälter entnommen werden.

Gemäß Verfahrensschritt a) umfasst das Verfahren das Einfügen eines Präkursorgemisches mit einer Siliziumquelle, einer Kohlenstoffquelle und gegebenenfalls einem Dotierstoff in den Reaktor beziehungsweise insbesondere in den Reaktionsraum des Reaktors. Somit soll der Begriff Präkursorgemisch im Sinne der vorliegenden Erfindung insbesondere bedeuten, dass zumindest eine Siliziumquelle und eine Kohlenstoffquelle in dem Präkursorgemisch verwendet wird, unabhängig von deren Ausgestaltung, also ob die Kohlenstoffquelle und die Siliziumquelle beispielsweise als unterschiedliche Feststoffe, als unterschiedliche Substanzen in einem Feststoff beziehungsweise Feststoffpartikel, oder in gänzlich unterschiedlichen Formen vorkommen.

Die Siliziumquelle und die Kohlenstoffquelle dienen dazu, in dem weiteren Verfahren durch eine Reaktion der Kohlenstoffquelle mit der Siliziumquelle Siliziumcarbid ausbilden zu können. Daher sollten die Siliziumquelle und die Kohlenstoffquelle derart gewählt werden, dass diese bei den nachfolgend beschriebenen Bedingungen, insbesondere bei den folgenden Temperaturen, etwa bei Normaldruck (1bar) oder einem leichten Überdruck durch das vorbeschriebene Verfahren Siliziumcarbid ausbilden können.

Die Wahl der Siliziumquelle beziehungsweise der Kohlenstoffquelle ist somit nicht grundsätzlich beschränkt. Beispielsweise können unmittelbar Feststoffpartikel verwendet werden, die Kohlenstoff und Silizium in jedem der Partikel umfassen. Diese können beispielsweise erzeugbar sein durch einen Sol-Gel-Prozess. Beispielsweise kann es bevorzugt sein, wenn eine Partikelgröße verwendet wird, welche in einem Bereich von > 10µm bis ≤ 2mm beispielsweise in einem Bereich von ≥ 25µm bis ≤ 70µm liegt, um Siliziumcarbid-Fasern zu erzeugen. Die bei einem vorbeschriebenen Verfahren beziehungsweise in einer vorbeschriebenen Vorrichtung erzeugbaren Fasern können etwa einen Durchmesser in einem Bereich von 10nm bis 3µm aufweisen und/oder eine Länge von einigen Millimetern, etwa in einem Bereich ≥ 1mm bis ≤ 20mm, aufweisen.

Weiterhin kann, insoweit ein Dotierstoff verwendet wird und der Dotierstoff nicht in dem Feststoffgranulat aufweisend die Kohlenstoffquelle und die Siliziumquelle vorhanden ist und somit mit dem Feststoffgranulat gemäß Verfahrensschritt a) in den Reaktor überführt wird, in welchem die Temperaturbehandlung gemäß Verfahrensschritt b) stattfindet, der Dotierstoff etwa als Gas in den Reaktor gegeben werden, etwa ebenfalls durch die Zuführung, wobei sich die Mischung gemäß Verfahrensschritt a) unmittelbar in dem Reaktor vor der Temperaturbehandlung ausbilden kann. Dies kann insbesondere dann von Vorteil sein, wenn der Dotierstoff als Gas vorliegen kann. Beispielsweise kann in diesem Fall gasförmiger Stickstoff als Dotierstoff dienen.

Mit Bezug auf den Dotierstoff kann dieser ausgewählt werden auf Basis der gewünschten Dotierung. Es kann der Dotierstoff ebenfalls Bestandteil sein des Feststoffgranulats. Alternativ ist es aber auch denkbar, dass die Dotierung des sich bildenden Siliziumcarbids, etwa als sich bildende Fasern oder als 3C-Siliziumcarbid-Nanokristalle, wie dies nachstehend im Detail beschrieben ist, während der thermischen Behandlung über die Gasphase in dem Reaktor vorgenommen wird. Als Dotierungsmaterialien können für eine n-Dotierung bevorzugt Phosphor (P) oder Stickstoff (N) verwendet werden, was für eine Elektrode von größtem Vorteil ist, oder können für eine p-Dotierung Bor (B) oder Aluminium (Al) verwendet werden. Durch die Dotierung kann dabei eine besonders gute elektrische Leitfähigkeit des Elektrodenmaterials eingestellt werden.

Gemäß Verfahrensschritt b) umfasst das Verfahren weiterhin das Beaufschlagen des bei Verfahrensschritt a) bereitgestellten Gemisches in dem Reaktor mit einer Vergasungstemperatur. In diesem Verfahrensschritt sollten die Ausgangsmaterialien somit derart erhitzt werden, dass diese in die Gasphase übergehen. Dazu wird der Reaktor beziehungsweise der Reaktionsraum auf eine Temperatur erhitzt, die in einem Bereich liegt von ≥ 1400°C bis ≤ 2000°C, insbesondere ≥ 1600°C, beispielsweise in einem Bereich von ≥ 1650°C bis ≤ 1850°C, bevorzugt ≥ 1650°C bis ca.≤ 1700°C, etwa bei Normaldruck (1bar) oder einem leichten Überdruck. Im Detail können bei einer Einstellung der Temperatur in Verfahrensschritt b) auf einen vorbeschriebenen Bereich in besonders vorteilhafter Weise nanostrukturierte Fasern des Siliziumcarbids geformt werden. Dabei kann das Ausbilden eines Temperaturgradienten von Vorteil sein, so dass das Präkursorgemisch zumindest teilweise in die Gasphase übergehen kann an einer Position, die eine vergleichsweise höhere Temperatur aufweist und sich Siliziumcarbid-Fasern an der vergleichsweise geringeren Temperatur abscheiden können, nämlich an dem Substrat. Die Temperatur des Substrats ist um eine Temperatur verringert, die in einem Bereich von ≥ 50°C bis ≤ 100°C liegt, verglichen zu der grundsätzlich in dem Reaktor eingestellten Temperatur in dem vorgenannten Bereich von ≥ 1400°C bis ≤ 2000°C, insbesondere ≥ 1600°C, beispielsweise in einem Bereich von ≥ 1650°C bis ≤ 1700°C.

Dabei kann es ferner durch die Einstellung der Temperatur ermöglicht werden, dass das erzeugte Siliziumcarbid nanokristallin ist und im Detail eine kubische 3C-Struktur des Siliziumcarbids ermöglicht wird. Insbesondere, wenn das Siliziumkarbid (SiC) als Siliziumkarbid-Einkristall, vorzugsweise als monokristallines kubisches 3C-SIC vorliegt, vereinen die einkristallinen Siliziumkarbid-Fasern eine hohe thermische Leitfähigkeit. Unter einem nanostrukturierten Siliziumcarbid kann insbesondere verstanden werden ein Siliziumcarbid, welches in wenigstens einer Dimension eine maximale räumliche Ausdehnung im Nanometerbereich, insbesondere von kleiner oder gleich 100nm, aufweist, wobei die untere Grenze durch das Herstellungsverfahren begrenzt sein kann. Insbesondere kann die Größe der Partikel des Feststoffgranulats gemäß Verfahrensschritt a) die untere Grenze der Partikel des Siliziumcarbids definieren, da hier meist eine Größe von 70% der Ausgangsgröße beziehungsweise der Größe der Partikel des Feststoffgranulats vorliegen kann, wobei die Untergrenze bei den Fasern bestimmt werden kann durch die Temperatur am Wachstumsort, den eingestellten Temperaturgradienten und die Zeit zum Wachsen der Fasern.

Somit kann durch das gezielte Einstellen eines Temperaturgradienten zwischen dem Reaktor und dem Substrat es ermöglicht werden, dass sich kristallines Siliziumcarbid an dem Substrat durch Einstellen einer Kristallisierungstemperatur abscheidet. Dabei können durch eine gezielte Einstellung der Temperatur, die in einem Bereich von ≥ 1400°C bis ≤ 2000°C, insbesondere ≥ 1600°C, beispielsweise in einem Bereich von ≥ 1650°C bis ≤ 1850°C, bevorzugt ≥ 1650°C bis ca.≤ 1700°C, in dem Reaktor und einer vergleichsweise um etwa ≥ 50°C bis ≤ 100°C reduzierten Temperatur des Substrates es ermöglicht werden, dass sich kristalline Fasern des Siliziumcarbids abscheiden. Es wird somit ersichtlich, dass die Kristallisierungstemperatur geringer ist, als die Vergasungstemperatur und dass ferner die Vergasungstemperatur der vorbeschriebenen ersten Temperatur T₁ entsprechen kann und dass die Kristallisierungstemperatur der vorbeschriebenen zweiten Temperatur T₂ entsprechen kann.

Mit Bezug auf Fasern können dies insbesondere Gebilde sein, bei denen das Verhältnis von Länge zu Durchmesser mindestens größer oder gleich 3:1 ist, beispielsweise bei größer oder gleich 10:1, insbesondere größer oder gleich 100:1, beispielsweise größer oder gleich 1000:1. Beispielsweise können gezielt Fasern mit einem Durchmesser in einem Bereich von ≥ 10nm bis ≤ 3µm und einer Länge von einigen Millimetern, etwa in einem Bereich ≥ 1mm bis ≤ 20mm erzeugt werden.

Gemäß den Verfahrens schritten d) und e) umfasst das Verfahren ferner das Bewegen des Substrats zu dem Abstreifer und das Überführen des gebildeten Siliziumcarbids in den Sammelbehälter durch Lösen des gebildeten Siliziumcarbids von dem Substrat unter Entlangbewegen des Substrats an dem Abstreifer. Diese Verfahrensschritte dienen dazu, auf kontinuierliche Weise das erzeugte Siliziumcarbid von dem Substrat zu entfernen und in dem Sammelbehälter aufzufangen beziehungsweise zu lagern.

Dabei können insbesondere durch die Verfahrgeschwindigkeit des Substrats beziehungsweise die Kristallisiserungsdauer an einem Bereich des Substrats die Eigenschaften der erzeugten Fasern geändert beziehungsweise angepasst werden.

Das vorgenannte Verfahren kann dabei beispielsweise dazu geeignet sein, Siliziumcarbid-Fasern als Elektrodenmaterial für eine Batterie, wie insbesondere eine Lithium-Ionen-Batterie zu erzeugen. Denn, wie dies vorstehend erläutert ist. kann durch die guten thermischen Eigenschaften das Thermo-Management der Batterie verbessert werden. Ferner kann die chemische und thermische Haltbarkeit der Fasern für eine Langzeitstabilität von Vorteil sein und kann die Flexibilität des Siliziumcarbids, insbesondere als Fasern, für eine hohe Zyklenstabilität von Vorteil sein. Denkbar im Rahmen der vorliegenden Erfindung sind jedoch auch polykristalline Formen des Siliziumkarbids. Vorteilhaft ist ferner, dass Siliziumcarbid als Elektrodenmaterial eine hohe Kapazität aufweisen kann, so dass ein wie beschrieben hergestelltes Elektrodenmaterial ferner eine gute Leistungsfähigkeit einer Batterie ermöglichen kann.

Weitere Anwendungen des so hergestellten Siliziumcarbids umfassen etwa Bereiche der Photonik, wie beispielsweise Solarzellen, als welche entsprechend unterschiedlich dotierte Siliziumcarbidfasern wirken können, LEDs, bei denen beispielsweise organische Leuchtflächen in Leuchttextilen vorgesehen sein können, die auf Siliziumcarbid basieren, oder auch die Strukturverstärkung, etwa von anderen Fasern.

Dabei ist das Verfahren sehr effektiv, da in einer beispielhaften Vorrichtung etwa 2000m² in 24h erzeugt werden können.

Hinsichtlich weiterer Vorteile und technischer Merkmale des vorbeschriebenen Verfahrens wird hiermit explizit auf die Beschreibung der Vorrichtung sowie auf das Beispiel, die Figur und die Beschreibung der Figur Bezug genommen, und umgekehrt.

Nachfolgend wird die Erfindung unter Bezugnahme auf die anliegende Zeichnung und anhand eines bevorzugten Ausführungsbeispiels exemplarisch erläutert, wobei die nachfolgend dargestellten Merkmale sowohl jeweils einzeln als auch in Kombination einen Aspekt der Erfindung darstellen können, und wobei die Erfindung nicht auf die folgende Zeichnung, die folgende Beschreibung und das folgende Ausführungsbeispielbeschränkt ist.

Es zeigt:

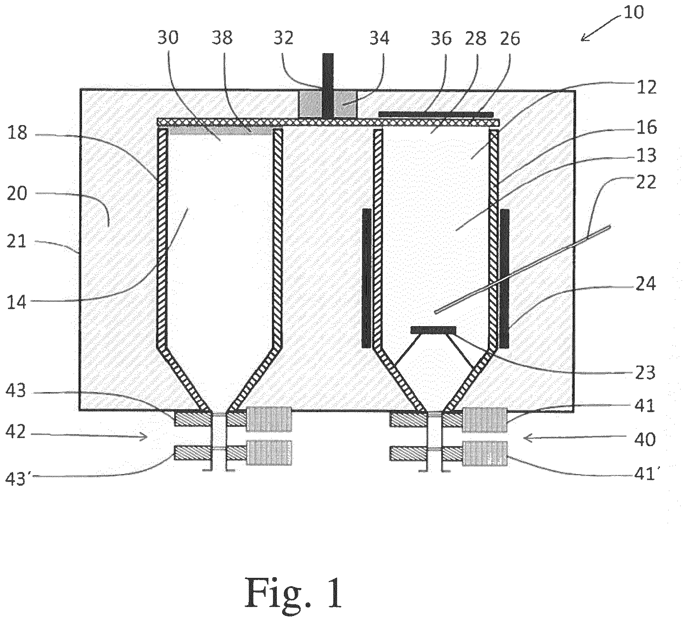

- Fig. 1: eine schematische Schnittansicht einer Vorrichtung gemäß der Erfindung.

In der Figur 1 ist eine schematische Schnittansicht einer Vorrichtung 10 zum kontinuierlichen Herstellen von kristallinem Siliziumcarbid gezeigt. Die Vorrichtung 10 umfasst einen Reaktor 12 und einen von dem Reaktor 12 zumindest teilweise räumlich getrennten Sammelbehälter 14. Der Reaktor 12 kann dabei eine Wandung 16 und der Sammelbehälter 14 kann ferner eine Wandung 18 aufweisen, wobei die Wandungen 16, 18 den Reaktor 12 beziehungsweise den Sammelbehälter 14 begrenzen. Ferner sind der Reaktor 12 und der Sammelbehälter 14 von einer Matrix 20 umgeben, wobei die Matrix 20 etwa einen Schutzgasüberdruck und/oder thermische Isolierungen und/oder Temperiermittel, wie etwa eine Wasserkühlung, aufweisen beziehungsweise ermöglichen kann. Beispielsweise kann die Matrix 20 außen durch eine Wandung 21, wie etwa einen Stahlmantel abgeschlossen werden. Weiterhin können, etwa in einer grundsätzlichen aber nicht beschränkenden Richtung von außen nach innen, eine Wasserkühlung, eine Isolierung, beispielsweise umfassend Kohlenstofffaser verstärkten Kohlenstoff (englisch: carbon fiber carbon composite, CFC), Graphitfilz und Graphitschaum von der Matrix umfasst sein, wobei sich an den Graphitschaum und/oder an den Graphitfilz die Wandungen 16, 18 anschließen können. Durch das Vorsehen der Matrix 20 und insbesondere der Wandung 21 kann es ermöglicht werden, dass die Vorrichtung 10 zu ihrer äußeren Hülle, der Wandung 21, thermisch isoliert und verschlossen ist, so dass die Vorrichtung 10 als Öffnungen lediglich die Zuführung 22 und die Materialschleusen 40, 42 aufweisen braucht, wie dies nachstehend beschrieben ist.

Die Wandung 16 des Reaktors 12 kann beispielsweise Graphit aufweisen oder aus Graphit bestehen. Beispielsweise kann die Wandung 16 zumindest teilweise, beispielsweise vollständig, aus einer gewickelten Graphitfolie ausgestaltet sein. Beispielhafte Wandstärken liegen etwa in einem Bereich von ≥ 5mm bis ≤ 15mm, etwa bei 10mm.

Um die Ausgangsstoffe der Siliziumcarbid-Bildung in den Reaktor 12 zu überführen, ist ferner die gegebenenfalls verschließbare Zuführung 22 zum Zuführen eines Präkursorgemisches vorgesehen. Die Zuführung 22 kann beispielsweise in einem Reaktionsraum 13 oberhalb eines Vergasungstellers 23 enden, auf welchem die Präkursormischung angeordnet werden kann und dort durch Temperatureinfluss in die Gasphase übergeht.

Für ein Durchführen der Reaktion ist es ferner vorgesehen, dass das Innere des Reaktors 12, also insbesondere der durch die Wandung 16 umschlossene Reaktionsbereich 13 beziehungsweise das hierin befindliche Gasvolumen, auf eine erste Temperatur T₁, die Vergasungstemperatur, temperierbar ist. Hierfür ist ein Temperiermittel 24 zum Temperieren des Reaktors 12 vorgesehen. Das Temperiermittel 24 kann beispielsweise ein an sich bekanntes Heizelement sein.

Um ein Abscheiden von Siliziumcarbid zu ermöglichen, ist ferner ein Substrat 26 zum Abscheiden von kristallinem Siliziumcarbid vorgesehen, welches zum Abscheiden von kristallinem Siliziumcarbid in oder benachbart zu dem Reaktor 12 beziehungsweise dem Reaktionsraum 13 anordbar ist. Gemäß Figur 1 ist das Substrat 26 oberhalb des Reaktors 12 angeordnet. Im Detail ist gezeigt, dass der Reaktor 12 und der Sammelbehälter 14 als kopfseitig geöffnete Behälter ausgebildet sind, wobei das Substrat 26 oberhalb kopfseitiger Öffnungen 28, 30 des Reaktors 12 und des Sammelbehälters 14 angeordnet ist. Der Bereich des Substrats 26, der sich oberhalb des Reaktors 12 beziehungsweise oberhalb der Öffnung 28 befindet, ist dabei in der Abscheideposition des Substrats 26 angeordnet.

Es ist ferner gezeigt, dass das Substrat 26 als rotierbare Scheibe ausgebildet ist. Das Substrat 26 ist damit durch ein Rotieren der Scheibe um die Scheibenachse zumindest bereichsweise von dem Reaktor 12 zu dem Sammelbehälter 14 bewegbar. Ein Rotieren kann dabei erfolgen etwa durch einen auf eine Welle 32 wirkenden Drehantrieb, wobei die Welle 32 in einem Lager 34 gelagert sein kann. Dabei ist, um ein Abscheiden von kristallinem Siliziumcarbid an dem Substrat 26 zu ermöglichen, ein weiteres Temperiermittel 36 zum Temperieren des Substrats 26 vorgesehen, wobei das vorbeschriebene Temperiermittel 24 zum Temperieren des Reaktors 12 und das Temperiermittel 36 zum Temperieren des Substrats 26 getrennt voneinander ansteuerbar sind. Dadurch wird ermöglicht, dass das Substrat 26 auf eine von der ersten Temperatur T₁ verschiedene zweite Temperatur T₂, die Kristallisierungstemperatur, temperierbar ist.

In der Figur 1 ist es ferner gezeigt, dass ein insbesondere feststehender und etwa aus Siliziumcarbid geformter Abstreifer 38 derart angeordnet ist, dass nach oder bei einem zumindest bereichsweisen Bewegen des Substrates 26 zu dem Sammelbehälter 14 an dem Substrat 26 abgeschiedenes kristallines Siliziumcarbid durch den Abstreifer 38 von dem Substrat 16 lösbar und das gelöste kristalline Siliziumcarbid in den Sammelbehälter 14 überführbar ist. Beispielsweise kann der Abstreifer 38 benachbart zu der als Einfallöffnung ausgebildeten Öffnung 30 des Sammelbehälters 14 angeordnet sein derart, dass das von dem Substrat 26 gelöste kristalline Siliziumcarbid in den Sammelbehälter 14 fällt.

Es sind ferner die Materialschleusen 40, 42 gezeigt, die ein Entfernen von Feststoffen aus dem Sammelbehälter 14 beziehungsweise aus dem Reaktor 12 ermöglichen. Beispielsweise weisen die Materialschleusen 40, 42 jeweils ein oder gemäß Figur 1 zwei Schiebeelemente 41, 41'; 43, 43' auf, die etwa durch Druckluft gesteuert werden können.

Bei einer vorbeschriebenen Vorrichtung 10 wird es somit erlaubt, dass durch die Zuführung 22, etwa mit Hilfe eines kommerziellen Pulverförderers, das Präkursormaterial mit Argon oder Stickstoff in den Reaktionsraum 13 des Reaktors 12 eingefüllt, etwa eingeblasen, wird. Vorzugsweise geschieht dies taktweise. Der Präkursor wird teilweise direkt beim Eintritt in dem heißen Schutzgas-gefüllten Zylinder vergast oder, wenn es sich um größere Präkursorpartikel handelt, langsam auf dem Vergasungsteller 23 in die Gasphase überführt. Aus der Gasphase in einem Temperaturgradienten, der sich aus der Wirkung der Temperierelemente 24, 36 bildet, wachsen SiC-Fasern an der Unterseite des als Scheibe ausgestalteten Substrats 26 über dem eben beschriebenen Zylinder beziehungsweise Reaktor 12. Um den Temperaturgradienten reproduzierbar und genau einstellen zu können, wird das Substrat 26 von oben im Bereich des Reaktors 12 mit dem Temperierelement 36 beheizt.

An der rotierenden Scheibe haftend werden die Fasern vom Entstehungsort zu dem Sammelbehälter 14 transportiert und dort mit dem Abstreifer 38 von der rotierenden Scheibe beziehungsweise dem Substrat 26 gelöst. Die Fasern fallen in den darunterliegenden Sammelbehälter 14 und können durch die Materialschleuse 42 entnommen werden, ohne dass der Betrieb und das Faserwachstum unterbrochen oder beeinträchtigt werden. Ferner kann überschüssiges beziehungsweise nicht abreagiertes Präkursormaterial dem Reaktor 12 durch die Materialschleuse 40 entnommen werden.

Im Folgenden wird ein beispielhaftes Verfahren beschrieben, durch welches unter Verwendung der vorbeschriebenen Vorrichtung Silizizumcarbid als nanokristalline Fasern herstellbar ist.

### Beispiel:

Im Folgenden wird die chemische Zusammensetzung, Sol-Gel-Aufbereitung mit verschiedenen Trocknungsschritten bei 70°C bis 200°C, mit abschließender Gewinnung des Feststoffgranulates aufweisend Silizium und Kohlenstoff bei 1000°C beschrieben, um ein in den Reaktor 12 einfüllbares Präkursorgemisch aufweisend eine Kohlenstoffquelle und eine Siliziumquelle zu erhalten. Anschließend wird basierend auf dem zuvor hergestellten Feststoffgranulat das Erzeugen von nanokristallinen Fasern von Siliziumcarbid beschrieben.

Flüssigzucker, Tetraethylorthosilikat und Ethanol werden zu einem Sol vermischt und bei 60 - 70°C unter Luftabschluss zum Gelieren gebracht. Die Zusammensetzung für einen Ansatz betrug (a) eine kolloidale Suspension aus 135g Tetraethylorthosilikat (TEOS) in 168,7g Ethanol gelöst als Siliziumquelle und (b) eine Lösung aus 68g Sacharose als Kohlenstoffquelle, in 75g destilliertem Wasser, der 37,15g Salzsäure (HCl) als Katalysator zum Ausbilden von Invertzucker hinzugefügt wird. Anschließend wurde Lösung (a) mit dem Flüssigzucker (b) unter Rühren miteinander vermischt. Alternativ kann anstatt der Lösung (b) auch direkt Flüssigzucker (Invertzucker, 122g 70%ig) verwendet werden. Dann wird kein Wasser zugesetzt und nur sehr wenig Salzsäure (5.2g), da diese nur noch zum Start des Gelierprozesses benötigt wird. Dieses Sol wird bei 50°C gealtert und anschließend bei 150 - 200°C getrocknet.

Für die Herstellung von SiC-Fasern wird vorzugsweise gröberes Granulat benötigt (einige 10 µm), so dass bei dem Altern und/oder bei dem Trocknen zeitweises Rühren erfolgt. Dieses Granulat beziehungsweise Pulver wird von verbliebenen ungewünschten Reaktionsprodukten bei 1000°C im Stickstoff- oder Argon-Gasstrom befreit und abschließend ggf. gemahlen.

Ferner kann eine Modifikation des SiC-Präkursors zum Zweck der Dotierung von SiC-Nanofasern erfolgen. Eine n-Dotierung kann etwa mit Stickstoff (beispielhafte Additive: Salpetersäure, Ammoniumchlorid, Kaliumnitrat oder Melamin), oder mit Phosphor (beispielhafte Additive: Kaliumdihydrogenphosphat oder Di-Natrium- Hydrogenphosphat) erfolgen. Eine p-Dotierung kann beispielhaft mit Bor (beispielhaftes Additiv: Di-Natriumtetraborat) oder mit Aluminium (beispielhaftes Additiv: Aluminiumpulver) erfolgen. Die Dotierstoffe können dem vorbeschriebenen Sol beigegeben werden, die Mengen sind abhängig von dem konkreten Additiv und der gewünschten Dotierkonzentration.

Das vorbeschriebene Pulver kann als Präkursorgemisch dienen, welches im Folgenden in dem Reaktor 12 zu Siliziumcarbid ungesetzt wird.

Der Reaktor 12 wird auf eine Temperatur von 1800°C im Präkursorvergasungsbereich beziehungsweise Reaktionsbereich 13 eingestellt. Das Substrat 26 wird bei einer Temperatur von 1750°C betrieben. Die Umdrehungszeit des als Substratscheibe ausgebildeten Substrats 26 wird so gewählt, dass sie in 4 Stunden eine volle Umdrehung erreicht. Über die Zuführung 22 in den als Zylinder ausgebildeten Reaktor 12 wird mit Argongasunterstützung über einen Pulverdosierer eine Menge von 30g des vorbeschrieben hergestellten Präkursors in den Reaktor 12 beziehungsweise in seinen Reaktionsraum 13 eingeblasen. Dies wird in Abständen von 15 Minuten wiederholt. Das verwendete Präkursor-Granulat hat eine Körnung von 10 bis 60 µm. Bei den gewählten Parametern entstehen 3C-SiC-Nanofasern mit Durchmessern von weniger als 100 nm und Längen von 15 bis 20 mm. Die gewachsenen Fasern werden über den Abstreifer 38 in dem Sammelbehälter 14 gesammelt und über die Materialschleuse 42, beispielsweise nach 24 h ohne Prozessunterbrechung, entnommen. Dabei besteht die Möglichkeit, etwa über ein Gassystem, die erzeugten Fasern in einen Schutzgas-gefüllten oder evakuierten Behälter zu entleeren, womit eine Kontamination der Fasern ausgeschlossen wird. Über die Materialschleuse 40 kann nicht vergastes Präkursorgranulat aus dem Reaktor 12 entnommen werden. Beide Einrichtungen (Sammelbehälter 14 und Reaktor 12) sind so ausgelegt, dass eine Materialentnahme üblicherweise erst nach 4 bis 6 Tagen notwendig wird. Größere Faserdurchmesser werden bei höheren Reaktionstemperaturen erhalten, z. B. 1850°C im Vergasungsraum und 1800°C an dem Substrat 26. Geringere Umdrehungszahlen führen zu einer größeren Verweildauer der wachsenden Fasern im Reaktor 12 und führen zu längeren Fasern.

## Patentansprüche

1. Vorrichtung zum kontinuierlichen Herstellen von kristallinem Siliziumcarbid, aufweisend
- einen Reaktor (12) und
- einen von dem Reaktor (12) zumindest teilweise räumlich getrennten Sammelbehälter (14), wobei
- der Reaktor (12) eine Zuführung (22) zum Zuführen eines Präkursorgemisches aufweist,
- ein Substrat (26) zum Abscheiden von kristallinem Siliziumcarbid vorgesehen ist,
- ein Reaktionsraum (13) des Reaktors (12) auf eine erste Temperatur T₁ und das Substrat (26) auf eine von der ersten Temperatur T₁ verschiedene zweite Temperatur T₂ temperierbar ist, wobei der Reaktor (12) auf eine Temperatur erhitzbar ist, die in einem Bereich von ≥ 1400°C bis ≤ 2000°C liegt und wobei die Temperatur des Substrats (26) um eine Temperatur verringerbar ist, die in einem Bereich von ≥ 50°C bis ≤ 100°C liegt, verglichen zu der grundsätzlich in dem Reaktor (12) eingestellten Temperatur in dem vorgenannten Bereich von ≥ 1400°C bis ≤ 2000°C, wobei
- das Substrat (26) zum Abscheiden von kristallinem Siliziumcarbid in einer Abscheideposition in oder benachbart zu dem Reaktionsraum (13) anordbar ist und zumindest bereichsweise von der Abscheideposition zu dem Sammelbehälter (14) bewegbar ist, und wobei
- ein Abstreifer (38) derart angeordnet ist, dass nach oder bei einem zumindest bereichsweisen Bewegen des Substrates (26) zu dem Sammelbehälter (14) an dem Substrat (26) abgeschiedenes kristallines Siliziumcarbid durch den Abstreifer (38) von dem Substrat (26) lösbar und das gelöste kristalline Siliziumcarbid in den Sammelbehälter (14) überführbar ist.

2. Vorrichtung nach Anspruch 1, **dadurch gekennzeichnet, dass** das Substrat (26) als rotierbare Scheibe ausgebildet ist.

3. Vorrichtung nach einem der Ansprüche 1 oder 2, **dadurch gekennzeichnet, dass** der Abstreifer (38) benachbart zu einer Einfallöffnung des Sammelbehälters (14) angeordnet ist derart, dass das von dem Substrat (26) gelöste kristalline Siliziumcarbid in den Sammelbehälter (14) fällt.

4. Vorrichtung nach einem der Ansprüche 1 bis 3, **dadurch gekennzeichnet, dass** der Reaktor (12) und der Sammelbehälter (14) als kopfseitig geöffnete Behälter ausgebildet sind, wobei das Substrat (26) oberhalb kopfseitiger Öffnungen (28, 30) des Reaktors (12) und des Sammelbehälters (14) anordbar ist.

5. Vorrichtung einem der Ansprüche 1 bis 4, **dadurch gekennzeichnet, dass** eine Wandung (16) des Reaktors (12) Graphit aufweist.

6. Vorrichtung nach Anspruch 5, **dadurch gekennzeichnet, dass** die Wandung (16) des Reaktors (12) zumindest teilweise aus einer gewickelten Graphitfolie ausgestaltet ist.

7. Vorrichtung nach einem der Ansprüche 1 bis 6, **dadurch gekennzeichnet, dass** der Abstreifer (38) zumindest teilweise aus Siliziumcarbid ausgestaltet ist.

8. Vorrichtung nach einem der Ansprüche 1 bis 7, **dadurch gekennzeichnet, dass** ein Temperiermittel (24) zum Temperieren des Reaktors (12) vorgesehen ist und dass ein weiteres Temperiermittel (36) zum Temperieren des Substrats (26) vorgesehen ist, wobei das Temperiermittel (24) zum Temperieren des Reaktors (12) und das Temperiermittel (36) zum Temperieren des Substrats (26) getrennt voneinander ansteuerbar sind.

9. Vorrichtung nach einem der Ansprüche 1 bis 8, **dadurch gekennzeichnet, dass** der Sammelbehälter (14) und der Reaktor (12) jeweils eine Materialschleuse (40, 42) zum Austragen eines Feststoffes aufweisen.

10. Verfahren zum Herstellen von kristallinem Siliziumcarbid unter Verwendung einer Vorrichtung (10) nach einem der Ansprüche 1 bis 9, aufweisend die Verfahrensschritte:
a) Einfügen eines Präkursorgemisches mit einer Siliziumquelle, einer Kohlenstoffquelle und gegebenenfalls einem Dotierstoff in den Reaktor (12);
b) Beaufschlagen des in Verfahrensschritt a) bereitgestellten Präkursorgemisches mit einer Vergasungstemperatur in dem Reaktor (12), indem der Reaktor (12) auf eine Temperatur geheizt wird, die in einem Bereich von ≥ 1400°C bis ≤ 2000°C liegt;
c) Abscheiden von kristallinem Siliziumcarbid an dem Substrat (26) durch Einstellen einer Kristallisierungstemperatur an dem Substrat (26), wobei die Kristallisierungstemperatur in einem Bereich von ≥ 50°C bis ≤ 100°C niedriger liegt, als die grundsätzlich in dem Reaktor (12) eingestellte Temperatur in dem Bereich von ≥ 1400°C bis ≤ 2000°C;
d) Bewegen des Substrats (26) zu dem Abstreifer (38); und
e) Überführen des gebildeten Siliziumcarbids in den Sammelbehälter (14) durch Lösen des gebildeten Siliziumcarbids von dem Substrat (26) unter Entlangbewegen des Substrats (26) an dem Abstreifer (38).

## Claims

1. Device for continuously producing crystalline silicon carbide, comprising:
a reactor (12); and
a collecting container (14) spatially separated at least partially from the reactor (12), wherein
the reactor (12) has a supply means (22) for supplying a precursor mixture,
a substrate (26) for depositing crystalline silicon carbide is provided,
a reaction chamber (13) of the reactor (12) can be temperature controlled to a first temperature T₁ and the substrate (26) can be temperature controlled to a second temperature T₂ which is different from the first temperature T₁, wherein the reactor (12) can be heated to a temperature in a range of ≥ 1400°C to ≤ 2000°C and wherein the temperature of the substrate (26) can be decreased by a temperature in a range of ≥ 50°C to ≤ 100°C relative to the temperature set principally in the reactor (12) in the aforementioned range of ≥ 1400°C to ≤ 2000°C, wherein
the substrate (26) for depositing crystalline silicon carbide can be arranged in a deposition position in or adjacent to the reaction chamber (13) and is movable at least partially from the deposition position to the collecting container (14), and wherein
a wiper (38) is arranged such that after or during an at least partial movement of the substrate (26) to the collecting container (14) crystalline silicon carbide deposited on the substrate (26) can be separated by the wiper (38) from the substrate (26) and the separated crystalline silicon carbide can be transferred into the collecting container (14).

2. Device according to claim 1, **characterized in that** the substrate (26) is configured as a rotatable disc.

3. Device according to claim 1 or 2, **characterized in that** the wiper (38) is arranged adjacent to an inlet opening of the collecting container (14) such that the crystalline silicon carbide separated from the substrate (26) falls into the collecting container (14).

4. Device according to any one of claims 1 to 3, **characterized in that** the reactor (12) and the collecting container (14) are configured as head-side open containers, wherein the substrate (26) can be arranged above the head-side openings (28, 30) of the reactor (12) and the collecting container (14).

5. Device according to any one of claims 1 to 4, **characterized in that** a wall (16) of the reactor (12) comprises graphite.

6. Device according to claim 5, **characterized in that** the wall (16) of the reactor (12) is at least partially made of a wound graphite foil.

7. Device according to any one of claims 1 to 6, **characterized in that** the wiper (38) is at least partially made of silicon carbide.

8. Device according to any one of claims 1 to 7, **characterized in that** a temperature control means (24) for tempering the reactor (12) is provided and a further temperature control means (36) for tempering the substrate (26) is provided, wherein the temperature control means (24) for tempering the reactor (12) and the temperature control means (36) for tempering the substrate (26) are controlled separately from each other.

9. Device according to any one of claims 1 to 8, **characterized in that** the collecting container (14) and the reactor (12) each comprise a material lock (40, 42) for discharging a solid.

10. Method for producing crystalline silicon carbide by use of a device (10) according to any one of claims 1 to 9, comprising the steps:
a) inserting a precursor mixture with a silicon source, a carbon source and optionally a dopant into the reactor (12);
b) exposing the precursor mixture provided in step a) to a gasification temperature in the reactor (12) by heating the reactor (12) to a temperature in a range of ≥ 1400°C to ≤ 2000°C;
c) depositing crystalline silicon carbide on the substrate (26) by setting a crystallization temperature at the substrate (26), wherein the crystallization temperature is in a range of ≥ 50°C to ≤ 100°C lower than the temperature principally set in the reactor (12) in the range of ≥ 1400°C to ≤ 2000°C;
d) moving the substrate (26) to the wiper (38); and
e) transferring the formed silicon carbide into the collecting container (14) by separating the formed silicon carbide from the substrate (26) while moving the substrate (26) along the wiper (38).

## Revendications

1. Dispositif de fabrication en continu de carbure de silicium cristallin, présentant
- un réacteur (12) et
- un récipient de collecte (14) au moins partiellement séparé spatialement du réacteur (12), où
- le réacteur (12) présente une conduite d'alimentation (22) pour l'amenée d'un mélange de précurseur,
- un substrat (26) est prévu pour la précipitation de carbure de silicium cristallin,
- une chambre réactionnelle (13) du réacteur (12) est thermostatée à une première température T₁ et le substrat (126) est thermostaté à une deuxième température T₂ différente de la première température, où le réacteur (12) peut être chauffé à une température qui se situe dans une plage ≥ 1400 °C à ≤ 2000 °C et où la température du substrat (26) peut être diminuée à une température qui se situe dans une plage ≥ 50 °C à ≤ 100 °C en dessous de la température réglée de base dans le réacteur dans ladite précédente plage ≥ 1400 °C à ≤ 2000 °C, où
- le substrat (26) peut être disposé, pour la précipitation de carbure de silicium cristallin, dans une position de précipitation dans ou au voisinage de la chambre réactionnelle (13) et peut être déplacé au moins par endroits de la position de précipitation vers le récipient de collecte (14), et où
- un racloir (38) est disposé de telle manière qu'après ou lors d'au moins un déplacement partiel du substrat (26) vers le récipient de collecte (14), du carbure de silicium cristallin précipité sur le substrat (26) peut être détaché par le racloir (38) du substrat (26) et le carbure de silicium cristallin détaché peut être transféré dans le récipient de collecte (14).

2. Dispositif selon la revendication 1, **caractérisé en ce que** le substrat (26) est conçu sous la forme d'un disque rotatif.

3. Dispositif selon l'une des revendications 1 ou 2, **caractérisé en ce que** le racloir (38) est disposé au voisinage d'un orifice de déversement du récipient de collecte (14) de telle manière que le carbure de silicium cristallin détaché du substrat (26) tombe dans le récipient de collecte (14).

4. Dispositif selon l'une des revendications 1 à 3, **caractérisé en ce que** le réacteur (12) et le récipient de collecte (14) sont conçus sous forme de récipients ouverts du côté frontal, où le substrat (26) peut être disposé au-dessus d'orifices (28, 30) du côté frontal du réacteur (12) et du récipient de collecte (14).

5. Dispositif selon l'une des revendications 1 à 4, **caractérisé en ce qu'**une cloison (16) du réacteur (12) présente du graphite.

6. Dispositif selon la revendication 5, **caractérisé en ce que** la cloison (16) du réacteur (12) est conçue au moins partiellement à base d'un film de graphite enroulé.

7. Dispositif selon l'une des revendications 1 à 6, **caractérisé en ce que** le racloir (38) est conçu au moins partiellement à base de carbure de silicium.

8. Dispositif selon l'une des revendications 1 à 7, **caractérisé en ce qu'**un produit de thermostatation (24) est prévu pour la thermostatation du réacteur (12) et qu'un autre produit de thermostatation (36) est prévu pour la thermostatation du substrat (26), où le produit de thermostatation (24) pour la thermostatation du réacteur (12) et le produit de thermostatation (36) pour la thermostatation du substrat (26) peuvent être mis en marche de manière séparée l'un de l'autre.

9. Dispositif selon l'une des revendications 1 à 8, **caractérisé en ce que** le récipient de collecte (14) et le réacteur (12) présentent respectivement un sas pour la matière (40, 42) pour l'évacuation d'un solide.

10. Procédé de fabrication de carbure de silicium cristallin moyennant l'emploi d'un dispositif (10) selon l'une des revendications 1 à 9, présentant les étapes de procédé :
a) d'ajout d'un mélange de précurseur avec une source de silicium, une source de carbone et éventuellement une substance de dopage dans le réacteur (12) ;
b) de soumission du mélange de précurseur préparé dans l'étape de procédé a) à une température de dégazage dans le réacteur (12) en ce que le réacteur (12) est chauffé à une température qui se situe dans une plage ≥ 1400 °C à ≤ 2000 °C ;
c) de précipitation de carbure de silicium cristallin sur le substrat (26) par un réglage de la température de cristallisation sur le substrat (26), où la température de cristallisation se situe dans une plage de ≥ 50 °C à ≤ 100 °C plus bas que la température réglée de base dans le réacteur dans la plage ≥ 1400 °C à ≤ 2000 °C ;
d) de déplacement du substrat (26) vers le racloir (38) ; et
e) de transfert du carbure de silicium formé dans le récipient de collecte (14) par le détachement du carbure de silicium formé sur le substrat (26) moyennant un déplacement du substrat (26) le long du racloir (38).
